(19) Europäisches Patentamt / European Patent Office / Office européen des brevets

(11) **EP 2 279 557 B1**

(12) **FASCICULE DE BREVET EUROPEEN**

(45) Date de publication et mention
de la délivrance du brevet:
**21.06.2017 Bulletin 2017/25**

(51) Int Cl.:
***H03H 9/02*** *(2006.01)* ***H03H 9/24*** *(2006.01)*
***H03H 9/52*** *(2006.01)*

(21) Numéro de dépôt: **09730675.7**

(86) Numéro de dépôt international:
**PCT/EP2009/054100**

(22) Date de dépôt: **06.04.2009**

(87) Numéro de publication internationale:
**WO 2009/124914 (15.10.2009 Gazette 2009/42)**

(54) **FILTRE RESONANT A BASE DE MATRICE DE N/MEMS**

N/MEMS MATRIX RESONATOR FILTER

N/MEMS ARRAY BASED RESONATOR FILTER

(84) Etats contractants désignés:
**AT BE BG CH CY CZ DE DK EE ES FI FR GB GR
HR HU IE IS IT LI LT LU LV MC MK MT NL NO PL
PT RO SE SI SK TR**

(30) Priorité: **08.04.2008 FR 0852345**

(43) Date de publication de la demande:
**02.02.2011 Bulletin 2011/05**

(73) Titulaire: **Commissariat à l'Énergie Atomique
et aux Énergies Alternatives
75015 Paris (FR)**

(72) Inventeurs:
- **KHARRAT, Chady
  F-38500 Voiron (FR)**
- **COLINET, Eric
  F-38240 Meylan (FR)**

(74) Mandataire: **Ilgart, Jean-Christophe et al
BREVALEX
95, rue d'Amsterdam
75378 Paris Cedex 8 (FR)**

(56) Documents cités:
**EP-A- 1 475 856      US-A1- 2006 170 508**

- **SHENG-SHIAN LI ET AL: "A Micromechanical
  Parallel-Class Disk-Array Filter" FREQUENCY
  CONTROL SYMPOSIUM, 2007 JOINT WITH THE
  21ST EUROPEAN FREQUEN CY AND TIME
  FORUM. IEEE INTERNATIONAL, IEEE, PI, 1 mai
  2007 (2007-05-01), pages 1356-1361,
  XP031138187 ISBN: 978-1-4244-0646-3**
- **SHENG-SHIAN LI ET AL: "An MSI
  Micromechanical Differential Disk-Array Filter"
  SOLID-STATE SENSORS, ACTUATORS AND
  MICROSYSTEMS CONFERENCE, 2007. TRAN
  SDUCERS 2007. INTERNATIONAL, IEEE, PI, 1 juin
  2007 (2007-06-01), pages 307-311, XP031133190
  ISBN: 978-1-4244-0841-2**
- **JOHN R CLARK ET AL: "Parallel-Coupled
  Square-Resonator Micromechanical Filter
  Arrays" INTERNATIONAL FREQUENCY
  CONTROL SYMPOSIUM AND EXPOSITION, 2006
  IEEE, IEEE, PI, 1 juin 2006 (2006-06-01), pages
  485-490, XP031003748 ISBN: 978-1-4244-0074-4
  cité dans la demande**

## Description

## DOMAINE TECHNIQUE

L'invention concerne un filtre résonant pouvant par exemple être utilisé en tant que filtre RF (RadioFréquences).
L'invention s'applique particulièrement au domaine des télécommunications.

## ÉTAT DE LA TECHNIQUE ANTÉRIEURE

Il est connu de réaliser des filtres résonants à partir de résonateurs acoustiques de type SAW (à ondes acoustiques de surface) ou de QCR (résonateurs à cristal quartz). Ces résonateurs ont pour principal inconvénient leur taille relativement grande. Il existe également des résonateurs miniaturisés de type FBAR (résonateurs à ondes acoustiques de volume à couche) ou BAW (résonateurs à ondes acoustiques de volume) plus petits que les résonateurs acoustiques de type SAW ou QCR. Toutefois, de tels résonateurs sont tout de même encombrants notamment à cause de leurs membranes de support et sont de plus difficiles à fabriquer.
Pour résoudre ce problème d'encombrement, il est possible de réaliser des filtres RF à partir de résonateurs de type MEMS (Microsystèmes électromécaniques) présentant un encombrement réduit et une faible consommation. De plus, ces résonateurs permettent d'obtenir des hautes fréquences de résonance, des facteurs de qualités très élevés, et sont facilement réalisables. De tels résonateurs peuvent également être intégrés avec la partie électronique de traitement du filtre sur une même puce.
Il est connu de coupler mécaniquement plusieurs résonateurs MEMS afin d'implémenter des fonctions de traitement de signaux réalisables par des circuits de transistors, mais avec plus de puissance et une meilleure linéarité. Ces résonateurs couplés permettent d'obtenir différents types de filtrage sur une bande passante plus large que celle obtenue par un résonateur individuel. Toutefois, les réponses obtenues par des résonateurs couplés dépendent fortement des paramètres individuels des résonateurs utilisés et de leurs états de fonctionnement. Selon le but de l'application, le nombre de résonateurs utilisés varie et les éléments de couplage sont modifiés.
Le couplage mécanique de résonateurs MEMS présente plusieurs inconvénients, et notamment la dispersion des paramètres des résonateurs due aux aléas de la fabrication de résonateurs en grand nombre, menant à la mauvaise connaissance du système global, ainsi que la difficulté de son intégration à cause de sa taille plus grande. L'utilisation de NEMS (Nanosystèmes électromécaniques), bien que réduisant la taille du filtre, fait apparaître encore davantage de problèmes dus à l'augmentation de la complexité de la modélisation des couplages d'un grand nombre de résonateurs à l'échelle nanoscopique, révélant des réponses inattendues du système aux modes supérieurs de résonance. De plus, les NEMS fournissent des signaux de sortie d'amplitudes plus faibles que celles obtenues par des résonateurs MEMS, ce qui est un problème majeur en présence de bruit électronique, de transmission ou autre.
De plus, de tels couplages de résonateurs présentent des inconvénients liés à la non-linéarité et à des discontinuités dans la phase de la réponse. Enfin, un des problèmes très présents dans l'asservissement de tels systèmes est la variation de leurs paramètres avec leurs états de fonctionnement et l'environnement ambiant, ce qui réduit généralement les performances du circuit électronique associé.
Le document J.R. CLARK et al., "Parallel-Coupled Square-Resonator Micromechanical Filter Arrays", Proceedings of the 2006 IEEE International Frequency Control Symposium, pages 485 à 490, décrit la réalisation d'un filtre à partir de résonateurs MEMS couplés mécaniquement. Les résonateurs reliés en série permettent de diminuer les résistances série du système représentant l'amortissement. Les résonateurs MEMS sont également reliés en parallèle par des poutres de couplage de raideur plus faible pour augmenter la bande passante du système.
Afin de satisfaire à des caractéristiques de filtrage plus exigeantes ou réaliser des fonctions plus sophistiquées, un couplage d'un plus grand nombre de résonateurs peut être nécessaire (des centaines ou des milliers de résonateurs). Ceci complique énormément la fabrication d'un tel système et les paramètres des résonateurs sont alors plus dispersés et incertains. Par suite, les éléments de couplage nécessaires peuvent être mal calculés et les fréquences résonantes ainsi que les bandes passantes obtenues sont alors mal définies et les réponses obtenues se retrouvent finalement erronées par rapport aux réponses souhaitées. D'autres problèmes surgissent également tels que le bruit causé par les fluctuations thermiques, le bruit électronique et les lacunes dans la gestion de la puissance. De plus, les gains des réponses obtenues sont faibles et la phase globale de la réponse obtenue est inexploitable à cause de son importante distorsion. S'ajoute à ces problèmes le facteur de l'environnement qui modifie les facteurs de qualité des résonateurs et qui rend la partie électronique de traitement et de contrôle beaucoup moins performante par rapport au cas de fonctionnement nominal.
Le document « Design considerations for an acoustic MEMS filter » de S.-H. Shen, Microsystem Technologies 10, pages 585-591, 2004, décrit un dispositif faisant appel à des résonateurs MEMS pour réaliser un traitement de signaux acoustiques. Ce dispositif comporte un circuit électronique de traitement permettant de coupler les sorties de circuits de détection de la résonance de résonateurs MEMS différents afin d'obtenir une bande passante souhaitée.

Un tel dispositif implique toutefois l'utilisation d'une électronique de traitement imposante et encombrante afin de réaliser les commutations nécessaires au couplage des sorties des circuits de détection des résonateurs. De plus, la dispersion dans les réponses obtenues, due aux incertitudes liées au procédé de réalisation des résonateurs, n'est pas prise en compte et la réponse globale obtenue peut être éloignée de celle devant être théoriquement obtenue. Enfin, dans ce dispositif, des circuits de détection réalisent la conversion vibration - signal électrique pour chaque résonateur. Ces circuits de détection comprennent une électronique de traitement complexe et sont donc coûteux à réaliser compte tenu du nombre de résonateurs utilisés.

Voir aussi US 2006/0170508.

## EXPOSÉ DE L'INVENTION

Un but de la présente invention est de proposer un filtre résonant permettant de résoudre au moins en partie les problèmes de l'art antérieur et d'obtenir des performances élevées en matière de filtrage, de gain, de sélectivité ou d'élargissement de la bande passante, et de facilité de lecture et de contrôle.

L'invention a également pour but de fournir un filtre résonant peut encombrant et peu coûteux à réaliser.

Pour cela, l'invention propose un filtre résonnant comportant au moins une matrice de $n \times m$ résonateurs de type N/MEMS, c'est-à-dire de type NEMS ou MEMS, de dimensions sensiblement similaires et répartis sur n lignes et m colonnes, avec n et m entiers strictement supérieurs à 1. Ce filtre comporte pour chaque résonateur :

- des moyens d'actionnement aptes à exciter le résonateur par la commande d'un signal électrique d'entrée du filtre,
- des moyens de détection des déplacements du résonateur aptes à délivrer un signal électrique de sortie dont la valeur est fonction des déplacements détectés.

Une entrée du filtre, destinée à recevoir un signal électrique d'entrée du filtre, est reliée électriquement aux moyens d'actionnement de tous les résonateurs, les sorties des moyens de détection de tous les résonateurs étant reliées électriquement entre elles et à une sortie du filtre.

Ainsi, l'invention exploite un caractère spécifique des N/MEMS, à savoir la possibilité d'intégrer de manière massive un nombre important de résonateurs sur un même substrat, et qui exploite de manière positive les dispersions entre les résonateurs d'une même matrice, et/ou de matrices différentes, pour réaliser des fonctions de filtrage.

Bien que les résonateurs soient réalisés de manière à ce que leurs dimensions soient sensiblement similaires, des dispersions, dues aux incertitudes liées au procédé de réalisation des résonateurs, sont présentes et les résonateurs n'ont donc pas exactement la même taille. Les résonateurs, bien que réalisés selon des dimensions nominales similaires, n'ont donc pas des dimensions exactement similaires.

Le signal électrique destiné à être obtenu en sortie de la matrice correspond à la somme des réponses mécaniques de l'ensemble des résonateurs de chaque matrice. Ainsi, compte tenu de la pluralité de résonateurs utilisés, la moyenne de la réponse globale obtenue en sortie du filtre tend vers l'espérance de la réponse individuelle d'un résonateur. Il est donc possible de réaliser un filtre dont la réponse peut être caractérisée très précisément.

Une telle matrice exploite précisément le contrôle de la dispersion en fréquences des résonateurs unitaires afin d'obtenir le gabarit du filtre souhaité en fonction des applications visées. Contrairement aux dispositifs connus, la matrice tire partie de cette dispersion.

Un tel filtre peut être utilisé pour comparer précisément des fréquences ou générer des fréquences dans une étroite bande passante, par exemple dans la région des micro-ondes, ou sélectionner des signaux se trouvant dans une certaine plage de fréquences. Avec un tel filtre, la structure résonante globale peut être décrite par une sortie unique qui est la sortie du filtre.

Il peut notamment être utilisé dans des sous-systèmes RF tels des déphaseurs, des réseaux d'adaptation d'impédances, des antennes configurables, des filtres variables. En télécommunication par exemple, ce filtre peut être utilisé dans des systèmes d'émission/réception de conversion hétérodyne ou directe. Il peut être utilisé comme sélectionneur de canaux pour réduire les interférences des autres canaux ou comme filtre de rejet des signaux d'images qui apparaissent directement dans la bande IF (Fréquence Intermédiaire) en amont des convertisseurs de fréquences, ou encore pour supprimer les harmoniques d'ordres supérieurs générées par les non-linéarités dues au circuit électronique. D'autres applications comme les systèmes de contrôle de fréquence et des horloges, peuvent aussi faire appel à un tel filtre résonant sélectif.

Compte tenu de la structure du filtre qui peut être réalisée entièrement sur un seul substrat, son encombrement est considérablement réduit car il ne nécessite pas d'électronique complexe de traitement des signaux obtenus en sortie des moyens de détection des déplacements des résonateurs, ce qui en réduit également le coût.

Les résonateurs ne sont pas couplés mécaniquement entre eux, c'est-à-dire être découplés mécaniquement entre eux. Ainsi, on peut assurer une bonne dispersion des caractéristiques des résonateurs. Le découplage mécanique entre les résonateurs signifie notamment que d'un point de vue mécanique (mouvements), les résonateurs n'interagissent pas entre eux.

La matrice peut comporter un nombre de résonateurs tel que la moyenne de la réponse globale obtenue en sortie tend vers l'espérance de la réponse individuelle d'un résonateur.

Le filtre résonant peut comporter au moins une matrice de n × m résonateurs de type N/MEMS dont les dimensions sont partagées statistiquement autour de valeurs moyennes, par exemple sensiblement similaires.

La matrice peut également comporter un nombre de résonateurs tel que la réponse fréquentielle de la matrice (ou la réponse fréquentiel de chaque matrice lorsque le filtre comporte plusieurs matrices) présente une loi de distribution des pulsations correspondant à la loi de distribution des dispersions technologiques des résonateurs. Ainsi, on a un nombre suffisant de résonateurs dans une matrice pour pouvoir utiliser la dispersion technologique des résonateurs de cette matrice.

La réponse fréquentielle d'une telle matrice comportant les résonateurs peut être connue précisément et présenter peu de dispersion.

Les résonateurs peuvent être de type poutre, lesdites dimensions des résonateurs pouvant correspondre aux longueurs des poutres. Les structures mécaniques des résonateurs N/MEMS du filtre peuvent être de type poutre encastrée-libre (c'est à dire comportant une extrémité libre et une extrémité encastrée), poutre encastrée-encastrée (c'est-à-dire comportant deux extrémités encastrées), membrane, plaque, disque ou autres. Les déformations de ces résonateurs peuvent être des déformations en flexion, en extension de volume, en rotation ou encore en translation.

L'invention concerne un filtre résonnant comportant au moins deux matrices de n × m résonateurs de type N/MEMS répartis sur n lignes et m colonnes, avec n et m entiers strictement supérieurs à 1. Ce filtre peut comporter pour chaque résonateur :

- des moyens d'actionnement aptes à exciter le résonateur par la commande d'un signal électrique d'entrée du filtre,
- des moyens de détection des déplacements du résonateur aptes à délivrer un signal électrique de sortie dont la valeur est proportionnelle aux déplacements détectés.

Les dimensions des résonateurs de chacune des matrices sont sensiblement similaires les unes aux autres, et les dimensions des résonateurs d'une des deux matrices sont différentes des dimensions des résonateurs de l'autre des deux matrices.

Le filtre comporte au moins deux matrices présentant des réponses fréquentielles différentes.

Le filtre comporte plusieurs matrices, chaque matrice présentant une réponse fréquentielle différente. Les dimensions des résonateurs d'une matrice sont différentes des dimensions des résonateurs d'une autre matrice.

Une entrée du filtre, destinée à recevoir un signal électrique d'entrée du filtre, peut être reliée électriquement aux moyens d'actionnement des résonateurs des deux matrices, les sorties des moyens de détection des résonateurs des deux matrices pouvant être reliées électriquement entre elles et à une sortie du filtre.

Lors de l'actionnement des résonateurs des deux matrices par un même signal électrique d'entrée du filtre, des moyens de détection des résonateurs d'une des matrices peuvent être aptes à délivrer des signaux électriques de valeurs opposées aux valeurs de signaux électriques destinés à être délivrés par des moyens de détection de résonateurs de l'autre des matrices.

Le signal obtenu en sortie du filtre peut donc être de type différentiel.

La différence entre les dimensions des résonateurs de l'une des deux matrices et les dimensions des résonateurs de l'autre des deux matrices peut être comprise entre environ 1% et 50%.

Lorsque les structures mécaniques des résonateurs sont de type poutre, les différentes dimensions entre les structures mécaniques des résonateurs des deux matrices peuvent être les longueurs des poutres.

Les moyens d'actionnement d'au moins une partie des résonateurs peuvent être de type électrostatique.

Dans ce cas, des moyens d'actionnement de type électrostatique d'un résonateur peuvent comporter une première électrode formée par au moins une partie de la structure mécanique du résonateur à base d'un matériau électriquement conducteur et une seconde électrode espacée de la première électrode, une tension de commande pouvant être destinée à être appliquée entre les deux électrodes.

Il est possible que les secondes électrodes des moyens d'actionnement de type électrostatique des résonateurs soient formées par une seule électrode commune aux résonateurs de la matrice ou de plusieurs matrices du filtre. Ainsi, en utilisant des moyens d'actionnement communs à l'ensemble des résonateurs du filtre, une force homogène peut être appliquée sur l'ensemble des résonateurs.

La seconde électrode des moyens d'actionnement peut être commune à tous les résonateurs de la matrice.

Les moyens de détection d'au moins une partie des résonateurs peuvent être de type capacitif.

Dans ce cas, les moyens de détection de type capacitif d'un résonateur peuvent comporter des moyens de mesure de capacité entre une portion électriquement conductrice du résonateur et une électrode espacée de ladite portion électriquement conductrice.

De manière générale, le nombre des résonateurs N/MEMS utilisés dans le filtre dépendra de l'application envisagée, de la réponse souhaitée ainsi que d'autres contraintes telles que la taille des résonateurs ou les dimensions de la puce sur laquelle est réalisé le filtre. Une matrice peut comporter entre environ 50 résonateurs et 10000 résonateurs, ou entre 1000 résonateurs et 10000 résonateurs, ou entre 2000 résonateurs et 5000 résonateurs, ou au moins 50 résonateurs, ou au moins 1000 résonateurs. La matrice peut par exemple comporter environ 4800 résonateurs répartis sur 240 colonnes et 20 lignes. La disposition des résonateurs, c'est-à-dire le nombre de lignes et de colonnes de la matrice peut notamment dépendre des dimensions du substrat sur lequel est réalisé le filtre.

Les liaisons électriques présentes sur une matrice peuvent être formées par une couche à base d'un matériau conducteur reliant les sorties des moyens de détection des résonateurs entre elles.

Le filtre peut comporter une pluralité de matrices de résonateurs de type N/MEMS reliées électriquement et en parallèle les unes aux autres, dans lequel des moyens de détection des résonateurs d'une partie des matrices peuvent être aptes à délivrer des signaux électriques de valeurs opposées aux valeurs de signaux électriques destinés à être délivrés par des moyens de détection des résonateurs d'une autre partie des matrices.

Le filtre peut comporter une pluralité de matrices de résonateurs de type N/MEMS reliées électriquement et en parallèle les unes aux autres de sorte que le signal électrique destiné à être obtenu en sortie du filtre correspond à la somme des signaux électriques obtenus en sortie de chaque matrice.

Des moyens de détection des résonateurs d'au moins une des matrices peuvent être aptes à délivrer des signaux électriques de valeurs opposées aux valeurs de signaux électriques destinés à être délivrés par des moyens de détection des résonateurs d'au moins une autre des matrices. Le signal destiné à être obtenu en sortie du filtre peut être de type différentiel.

Des moyens de détection des résonateurs d'un nombre de matrices correspondant à la moitié du nombre total de matrices du filtre peuvent être aptes à délivrer des signaux électriques de valeurs opposées aux valeurs de signaux électriques destinés à être délivrés par des moyens de détection des résonateurs d'un nombre de matrices correspondant à la moitié du nombre total de matrices du filtre. Le signal destiné à être obtenu en sortie du filtre peut être de type différentiel.

Les dimensions des résonateurs de matrices aptes à délivrer lesdits signaux électriques de valeurs opposées peuvent être différentes des dimensions des résonateurs des autres matrices. La différence entre les dimensions des résonateurs de matrices aptes à délivrer lesdits signaux électriques de valeurs opposées et les dimensions des résonateurs des autres matrices peut être comprise entre environ 1% et 50% de la valeur d'une de ces dimensions.

Ledit filtre peut être réalisé sur un unique substrat, contribuant ainsi à résoudre les problèmes d'encombrement existants de l'art antérieur.

La caractéristique selon laquelle les matrices sont reliées électriquement entre elles et en parallèle les unes aux autres peut signifier que les entrées de chaque matrice, qui sont reliées électriquement aux moyens d'actionnement des résonateurs de chaque matrice, peuvent être toutes reliées électriquement à l'entrée du filtre et que les sorties de chaque matrice, qui sont reliées électriquement aux sorties des moyens de détection des résonateurs de chaque matrice, peuvent être toutes reliées électriquement à la sortie du filtre.

Les matrices peuvent être connectées électriquement entre elles par microcâblage (wirebonding en anglais).

L'invention concerne également un procédé de réalisation d'un filtre résonnant tel que décrit précédemment, dans lequel les résonateurs sont réalisés par gravure dans une couche à base d'un matériau conducteur disposée sur un substrat semi-conducteur, les portions restantes de la couche conductrice après l'étape de gravure formant les couplages électriques du filtre.

L'invention concerne également une structure résonante comportant plusieurs filtres résonants tels que décrits ci-dessus couplés électriquement en série les uns aux autres.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente un exemple de filtre résonant selon un mode de réalisation particulier, comportant plusieurs matrices de résonateurs ;
- la figure 2 représente schématiquement un exemple de matrice utilisée dans un filtre résonant selon un mode de réalisation particulier, du point de vue de la détection ;
- la figure 3 est un schéma fonctionnel d'une matrice d'un filtre résonant selon un mode de réalisation particulier ;
- la figure 4 représente un exemple de résonateur utilisé dans un filtre résonant, objet de la présente invention, selon un mode de réalisation particulier ;
- les figures 5 et 6 représentent graphiquement des valeurs du déplacement selon un axe y associé au premier mode de résonance d'un résonateur de type poutre comportant respectivement une seule et deux extrémités encastrées, utilisé dans un filtre résonant en fonction de la position sur un axe x ;

- la figure 7 représente le diagramme de Bode de la fonction de transfert d'un résonateur de type poutre utilisé dans filtre résonant approché par un modèle du deuxième ordre ;
- la figure 8 représente schématiquement la déflection et l'élongation de la poutre d'un résonateur utilisé dans un filtre résonant en fonction d'un rayon de courbure r ;
- la figure 9 représente un exemple de résonateur utilisé dans un filtre résonant associé à des moyens d'actionnement de type électrostatique ;
- la figure 10 représente à titre d'exemple des courbes de réponses fréquentielles de filtres résonants comportant pour l'un 6000 résonateurs NEMS avec $Q$ = 1500 et pour l'autre 3000 résonateurs NEMS avec $Q$ = 150 ;
- les figures 11 et 12 représentent respectivement la fréquence de résonance et la dérivée de cette fréquence de résonance d'un résonateur NEMS en fonction de la longueur de son corps dans le cas d'un résonateur de type poutre ;
- la figure 13 représente une réponse impulsionnelle globale d'un filtre résonant et la réponse impulsionnelle d'un seul résonateur NEMS utilisé dans ce filtre résonant ;
- les figures 14 et 15 représentent à titre d'exemple les réponses fréquentielles de filtres résonants ;
- la figure 16 représente les réponses fréquentielles d'un résonateur NEMS seul et d'un filtre résonant dont les sorties des matrices sont traitées de manière additive ou différentielle ;
- la figure 17 représente les réponses fréquentielles d'un résonateur NEMS seul, d'un filtre résonant, de deux filtres résonants en cascade et de trois filtres résonants en cascade, lorsque les sorties de ces filtres sont traitées de manière additive ;
- la figure 18 représente les réponses fréquentielles d'un résonateur NEMS seul et de deux filtres résonants en cascade lorsque les sorties sont traitées de manière additive ou différentielle.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

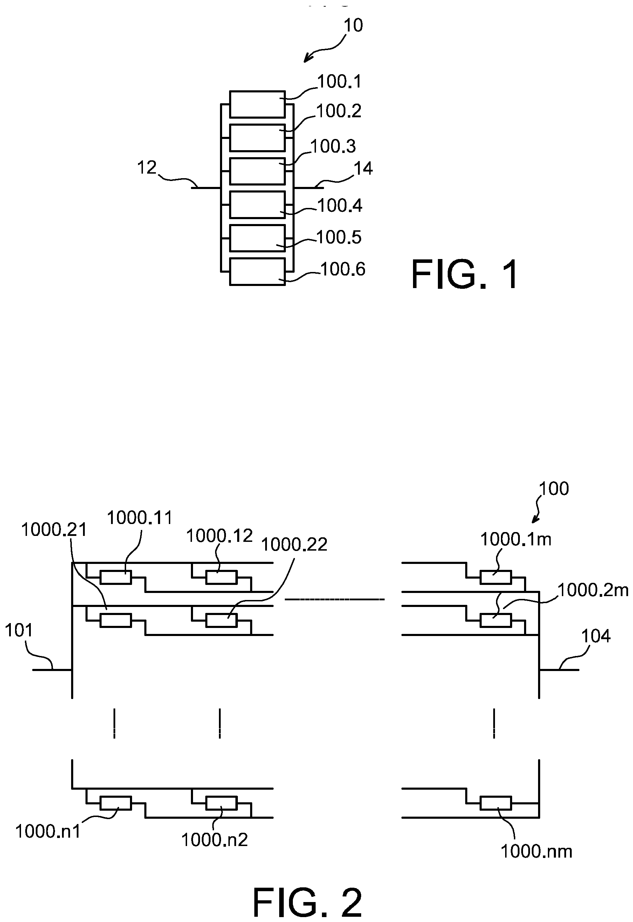

On se réfère tout d'abord à la figure 1 qui représente un filtre résonant 10 selon un mode de réalisation particulier.

Le filtre résonant 10 comporte six matrices 100.1 à 100.6 de résonateurs N/MEMS couplées électriquement en parallèle les unes aux autres. Sur la figure 1, ces matrices 100.1 à 100.6 sont connectées électriquement entre elles en parallèle. Dans une variante, les matrices 100.1 à 100.6 peuvent être connectées électriquement entre elles d'une manière différente, c'est-à-dire comporter des connexions de type série et/ou parallèle entre les matrices.

Les entrées de chaque matrice 100.1 à 100.6 sont reliées à une entrée 12 du filtre résonant 10 sur laquelle est appliqué un signal électrique d'entrée, correspondant au signal à filtrer, les sorties de ces matrices étant reliées à une sortie 14 du filtre 10. Dans ce mode de réalisation, les résonateurs des matrices 100.1 à 100.6 sont de type NEMS. Toutefois, les principes exposés dans cette description s'appliquent également à des résonateurs de type MEMS. Les structures des matrices 100.1 à 100.6 et des résonateurs de ces matrices sont détaillées plus loin.

Tous les résonateurs NEMS des matrices 100.1 à 100.6 forment une structure résonante soumise à une même force d'excitation de pulsation $\omega_e$, correspondant au signal d'entrée à filtrer appliqué sur l'entrée 12 du filtre 10. Cette force d'excitation est appliquée aux résonateurs par des moyens d'actionnement. Cette force d'excitation entraîne des amplitudes de déplacements oscillatoires des résonateurs différentes suivant les fonctions de transfert de chacune des matrices. Des moyens de détection permettent de délivrer un signal électrique de sortie en fonction des déplacements détectés des résonateurs.

On se réfère maintenant à la figure 2 qui représente schématiquement un exemple de matrice 100 de résonateurs NEMS utilisée dans le filtre résonant 10, représentée du point de vue de la détection des déplacements des résonateurs de la matrice.

Dans une telle matrice 100, des résonateurs NEMS 1000 sont par exemple réalisés dans une couche à base d'un matériau conducteur, par exemple un métal tel que de l'aluminium, initialement déposée sur une couche semi-conductrice, par exemple à base de silicium. La couche conductrice, et éventuellement la couche de semi-conducteur, sont gravées de manière à former les différents résonateurs NEMS 1000 ainsi que les connexions électriques entre les résonateurs 1000 représentées schématiquement sur la figure 2. La couche conductrice, et éventuellement la couche de semi-conducteur, forment donc un support commun conducteur permettant de coupler et d'interconnecter électriquement les résonateurs 1000 entre eux. La matrice 100, et plus généralement le filtre résonant 10, peut être réalisé à partir d'une structure de couches différentes de celle exposée ci-dessus et/ou à base de matériaux différents (par exemple un substrat SOI, ...).

Les résonateurs 1000 sont réalisés de manière à former une matrice de n × m résonateurs NEMS 1000 répartis sur n lignes et m colonnes, n et m étant des entiers supérieurs à 1. Sur la figure 2, les résonateurs 1000.11 à 1000.n1 forment la première colonne de la matrice 100, les résonateurs 1000.12 à 1000.n2 forment la deuxième colonne de la matrice 100, et ainsi de suite jusqu'aux résonateurs 1000.1m à 1000.nm formant la m-ième et dernière colonne de la matrice 100. Les résonateurs sont suffisamment éloignés les uns des autres, par exemple d'une distance au moins égale aux dimensions d'un résonateur, pour éviter tout couplage mécanique.

La matrice 100 comporte également une première entrée 102, non représentée sur la figure 2, sur laquelle est appliqué le signal électrique d'entrée se trouvant sur l'entrée 12 du filtre résonant 10, sous la forme d'une tension ou d'un courant. Ce signal est envoyé en entrée des moyens d'actionnement de tous les résonateurs 1000.11 à 1000.nm de la matrice 100 afin d'appliquer une force d'excitation de pulsation $\omega_e$, correspondant à la fréquence du signal d'entrée à filtrer, aux résonateurs.

La matrice 100 comporte également une seconde entrée 101, sur laquelle est appliqué un second signal électrique. Ce second signal est appliqué en entrée des résonateurs 1000.11 à 1000.nm. Les sorties de tous les résonateurs 1000.11 à 1000.nm, c'est-à-dire les sorties des moyens de détection de tous les résonateurs, sont reliées électriquement entre elles, ce qui permet d'obtenir sur une sortie 104 de la matrice 100 un signal représentant la somme des réponses mécaniques des résonateurs. L'amplitude du signal obtenu en sortie sera donc fonction du second signal électrique appliqué sur l'entrée 101. La manière dont les résonateurs et les moyens de détection sont connectés électriquement entre eux sur la figure 2 n'est qu'un exemple de réalisation et ces connexions pourraient être réalisées d'une manière différente (sorties des moyens de détection reliées en série les unes aux autres et/ou en parallèle et/ou une partie en série et d'autres en parallèle).

Dans une variante de réalisation, il est possible que le premier et le second signal ne soient qu'un seul et même signal comportant deux composantes distinctes, l'une étant utilisée pour la détection et l'autre étant utilisée pour l'actionnement.

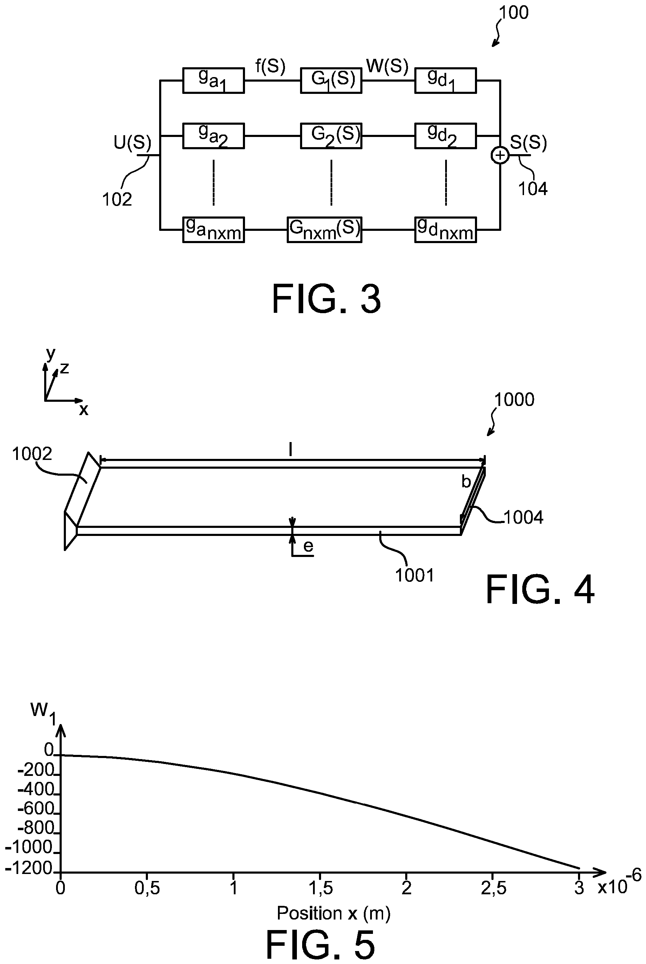

La figure 3 représente un schéma bloc fonctionnel de la matrice 100. Sur ce schéma, la matrice 100 est représentée sous la forme de N systèmes connectés en parallèle, chaque système représentant un résonateur associé à des moyens d'actionnement et des moyens de détection. Chaque système i comporte un premier bloc $g_{ai}$, un second bloc $G_i(s)$ et un troisième bloc $g_{di}$, avec i tel que $1 \leq i \leq n \times m$. Un signal U(s) représente le signal, par exemple une tension, appliqué sur l'entrée 102 de la matrice 100, et un signal S (s) représente le signal, par exemple une tension, récupéré sur la sortie 104 de la matrice 100.

Les blocs de chaque système représentent la fonction de transfert de chaque système de la matrice 100. Le bloc $g_{ai}$ représente le gain apporté par les moyens d'actionnement du résonateur i. Un signal $f(s)=g_{ai}.U(s)$ se trouve donc appliqué en entrée du bloc $G_i(s)$ représentant la fonction de transfert du résonateur i de la matrice 100. Un signal $w(s)= G_i(s).f(s)$ se trouve donc appliqué en entrée du bloc $g_{di}$ représentant le gain des moyens de détection utilisés pour détecter le signal obtenu en sortie du résonateur i. Le signal S(s) est alors récupéré sur la sortie 104 de la matrice 100, S(s) étant la somme des signaux obtenus en sortie des blocs $g_{di}$ des n × m systèmes.

On a donc par exemple un signal électrique d'entrée, courant ou tension, correspondant à un signal à filtrer qui est appliqué aux bornes d'entrée de tous les systèmes de la matrice 100. Ce signal électrique d'entrée est alors appliqué à tous les moyens d'actionnement des résonateurs. Les résonateurs sont excités de manière commandée par l'intermédiaire des moyens d'actionnement. Une détection des déplacements des résonateurs est réalisée, ces déplacements étant transformés en signaux électriques de sortie par les moyens de détection. Enfin, ces signaux électriques de sortie sont additionnés par connexion électrique pour donner un seul signal électrique de sortie correspondant au signal filtré par la matrice 100.

Un exemple de résonateur NEMS 1000 utilisé dans la matrice 100 est représenté sur la figure 4. Le résonateur 1000 est ici de type poutre, cette poutre étant de dimensions nanométriques. Il comporte un corps 1001 de sections selon les plans (y,z) et (x,z) sensiblement rectangulaires, de longueur 1, de largeur b et d'épaisseur e, formant ladite poutre. Le résonateur 1000 comporte une première extrémité 1002 encastrée et une seconde extrémité 1004 libre. Lorsque le résonateur 1000 se déplace sous l'effet d'une force excitante, le déplacement vibratoire maximal se produit alors au niveau de l'extrémité libre 1004.

Dans une variante, les deux extrémités 1002 et 1004 du résonateur NEMS 1000 pourraient être encastrées. Dans ce cas, lorsque le résonateur 1000 se déplace sous l'effet d'une force excitante, le déplacement vibratoire maximal se produit approximativement au milieu de la longueur 1 du corps 1001. De plus, le corps 1001 du résonateur 1000 peut avoir également une forme autre que celle représentée sur la figure 4, et notamment des sections autres que rectangulaires.

Le filtre résonant 10 utilise la fréquence naturelle de vibration des résonateurs NEMS 1000 pour transmettre des signaux de fréquences très précises tout en atténuant des signaux et bruits sur d'autres fréquences. En appliquant une force vibratoire de fréquence définie en entrée, les microstructures ou nanostructures mécaniques des résonateurs 1000 subissent une déflection ou un déplacement vibratoire à cette même fréquence et d'amplitudes proportionnelles à l'intensité du signal d'entrée, ces amplitudes devenant significatives en cas de résonance (fréquence d'actionnement ou d'excitation égale à la fréquence de résonance propre de la microstructure du résonateur 1000).

Le facteur de qualité $Q$ d'un résonateur 1000 est défini par le rapport de la fréquence de résonance du résonateur sur la largeur de sa bande passante (qui est délimitée par les fréquences où les amplitudes sont égales à la moitié de celle correspondant au pic de résonance du résonateur) et dépend notamment de l'amortissement dû à la viscosité du fluide ou du gaz environnant la structure mécanique du résonateur, ainsi que des paramètres mécaniques du résonateur (masse, rigidité du matériau utilisé, ...). La sélectivité d'un filtre résonant est proportionnelle aux facteurs de qualité des résonateurs utilisés. Mais l'intervalle de détection des fréquences se réduit lorsque l'on augmente le facteur de qualité, et la bande passante est donc plus étroite lorsque l'on utilise un résonateur à facteur de qualité élevé.

La réponse d'un des résonateurs 1000 est caractérisée par sa fonction de transfert correspondant au rapport de l'amplitude du déplacement mécanique du résonateur par rapport à la force appliquée en entrée du résonateur aux fréquences de fonctionnement. Cette force d'entrée résulte généralement de l'application d'une tension électrique aux bornes de moyens d'actionnement de la structure mécanique du résonateur. La sortie détectée, c'est-à-dire le déplacement de la structure mécanique du résonateur, peut alors être convertie électriquement par des moyens de détection.

De manière générale, les résonateurs 1000 utilisés dans la matrice 100 peuvent également être d'un type autre qu'une poutre, par exemple un disque.

Le comportement dynamique du déplacement transversal $w(x,t)$ de ce résonateur 1000 soumis à une force linéique distribuée $f(x,t)$ est décrit par la relation suivante :

$$EI\frac{\partial^4 w(x,t)}{\partial x^4} + c\frac{\partial w(x,t)}{\partial t} + \rho S\frac{\partial^2 w(x,t)}{\partial t^2} = f(x,t) \qquad (1)$$

où E est le module d'Young du résonateur, $I = b_e^3/12$ le moment d'inertie du résonateur, $S = b.e$ la section transversale du corps 1001 (section selon le plan (y,z)), $\rho$ la densité du matériau du résonateur et c le coefficient d'amortissement du matériau du résonateur.

En suivant la procédure de décomposition modale de Galerkin, on obtient :

$$w(x,t) = \sum_{k=1}^{n} a_k(t).w_k(x) \qquad (2)$$

tel que $\partial^4 w_k(x)/\partial x^4 = \lambda_k^4 w_k(x)$, avec

$a_k(t)$ : coefficient dynamique associé au k-ième mode de résonance ;
$\lambda_k$ : valeur propre de l'opérateur $\partial/\partial x$ ;
$w_k(x)$ : déplacement transversal associé au k-ième mode de résonance.

En se limitant au $1^{er}$ mode de résonance $w_1(x)$, le déplacement sur l'axe $y$ (représenté sur la figure 4) du résonateur 1000 est décrit par la relation :

$$w(x,t) = a(t).w_1(x) \qquad (3)$$

Dans le cas d'un résonateur comportant une extrémité libre comme sur la figure 4, on trouve $\lambda_1 = 1,8751/l$, et $\lambda_1 = 4,73/l$ lorsque les deux extrémités du résonateur 1000 sont encastrées.

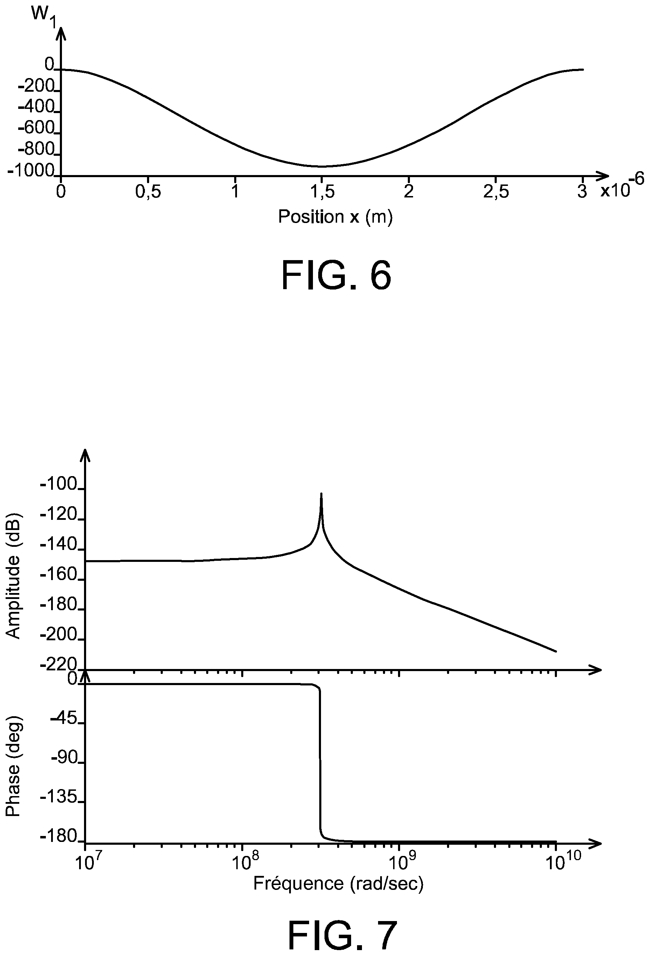

La figure 5 représente graphiquement la valeur de $w_1(x)$ en fonction de la position sur l'axe x, pour un corps 1001 de longueur égale à 3 $\mu$m. La figure 6 représente graphiquement cette même valeur de $w_1(x)$, dans le cas d'un résonateur comportant ses deux extrémités encastrées. Les courbes représentées sur ces deux figures représentent donc le profil de ces deux types de poutre dans le plan (x,y) selon les axes x et y représentés sur la figure 4, lors d'une résonance.

En considérant l'équation (1) appliquée au premier mode de résonance, on obtient l'équation dynamique du coefficient $a(t)$ suivante :

$$EI\lambda_1^4.a(t) + c.\dot{a}(t) + \rho S\ddot{a}(t) = f(t) \qquad (4)$$

On obtient alors à partir de l'équation (4) la fonction de transfert suivante :

$$\frac{a(s)}{f(s)} = G(s) = \frac{1/m}{s^2 + \dfrac{\omega_0}{Q}s + \omega_0^2} \tag{5}$$

avec $m = \rho.S$, $k = E.I.\lambda_1^4$, $\omega_0 = \sqrt{\dfrac{k}{m}}$ et $Q = \dfrac{\omega_0.m}{c}$.

La figure 7 représente le diagramme de Bode de cette fonction de transfert, correspondant à la réponse individuelle en fréquences du résonateur 1000, approché ici par un modèle du deuxième ordre. On voit sur cette figure 7 que l'on obtient un pic relativement étroit à la résonance, traduisant un facteur de qualité élevé du résonateur, ce qui s'applique particulièrement pour la réalisation du filtre 10.

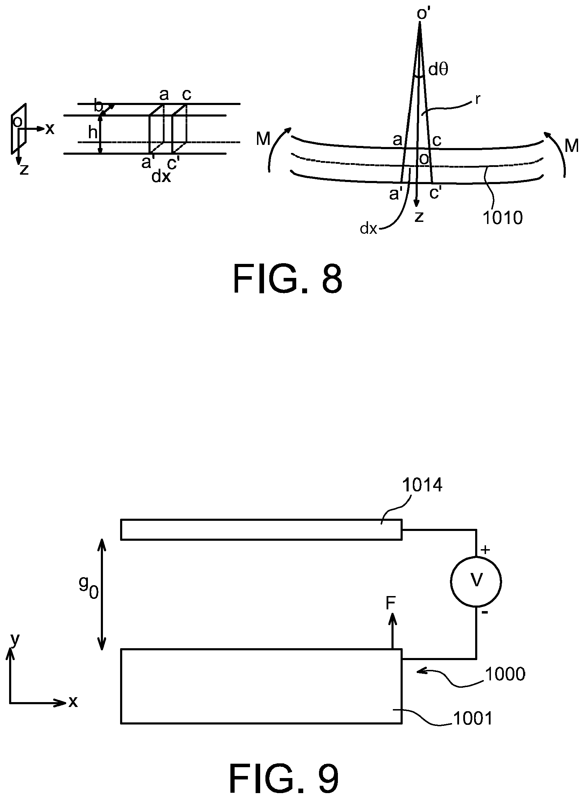

La figure 8 représente schématiquement la déflection et l'élongation de la poutre du résonateur 1000 en fonction d'un rayon de courbure r.

Pour une flexion qui résulte de l'élongation du résonateur suite à un actionnement, on a sur une ligne neutre 1010 qui ne subit pas d'élongation :

$$dx = r.d\theta$$

où r est le rayon de courbure.

Au niveau de la section transversale du corps 1001 du résonateur 1000 on a également :

$$dx_s = (r + h/2).d\theta \ .$$

La différence ($dx - dx_S$) exprime l'élongation subie par le corps 1001 et se traduit par l'équation suivante :

$$d(\delta l) = h/2.d\theta \ ,$$

ce qui par suite permet d'écrire que :

$$\delta l = \int_{\theta_1}^{\theta_2} \frac{h}{2} d\theta = \frac{h}{2} \int_0^{l_1} \frac{1}{r} dx \quad \text{avec} \quad \frac{1}{r} = \left| \frac{d^2 w(x,t)}{dx^2} \right| = w''(x).a(t)$$

On voit donc que $\delta l$ est proportionnel à $a(t)$ et donc proportionnel au déplacement sur n'importe quel abscisse défini du corps 1001 du résonateur 1000.

Les résonateurs 1000 utilisés par le filtre résonant 10 peuvent être actionnés par différents types de moyens d'actionnement linéaires, la force produite étant proportionnelle au signal électrique de commande.

Un exemple de résonateur 1000 associé à des moyens d'actionnement de type électrostatique est maintenant décrit en relation avec la figure 9.

Ces moyens d'actionnement comportent une première électrode 1014. Le corps 1001 du résonateur 1000, qui est à base d'un matériau métallique, forme une seconde électrode. Une tension V, correspondant par exemple à la tension appliquée en entrée du filtre résonant 10, est appliquée entre l'électrode 1014 et le corps 1001. Cette tension V génère une force électrostatique proportionnelle au carré de cette tension et inversement proportionnelle à la distance qui sépare les électrodes, à savoir ($g_0 - w$), $g_0$ étant la distance initiale entre le corps 1001 et l'électrode 1014 lorsque le résonateur 1000 est au repos, w étant la distance de déplacement du corps 1001 par rapport à sa position initiale lorsque celui-ci est soumis à la force électrostatique. Cette force électrostatique peut créer un déplacement latéral du corps 1001 dans le plan du corps 1001 ou un déplacement vertical hors plan, selon l'emplacement de l'électrode d'actionnement.

La force d'attraction F que subi le corps 1001, représentée par une flèche selon l'axe y sur la figure 9, peut s'exprimer par l'équation : $F = \dfrac{1}{2} \dfrac{\varepsilon_0 . S . V^2}{(g_0 - w)^2}$ avec $\varepsilon_0$ permittivité du vide.

Une force électrostatique oscillatoire de fréquence $\omega_e$ induit un mouvement vibratoire de la structure, c'est-à-dire du corps 1001, à la même fréquence et dont les amplitudes dépendent de la fonction de transfert du résonateur 1000. En considérant un faible déplacement w, la force électrostatique F s'exprime alors par :

$$F = \dfrac{1}{2} \dfrac{\varepsilon_0 . S . V^2}{g_0^{\,2}} + \dfrac{\varepsilon_0 . S . V^2}{g_0^{\,3}} . w$$

Le comportement dynamique du déplacement du corps 1001 du résonateur 1000 vis-à-vis de l'entrée $V^2$ est décrit par $g_a.G'(s)$ tel que $G'(s)$ est différent de G(s), fonction de transfert du résonateur 1000, par un léger décalage de la fréquence de résonance et du facteur de qualité dû à l'effet électrostatique non-linéaire, $g_a$ étant le gain des moyens d'actionnement du résonateur 1000.

Différents types de détection de vibrations des résonateurs sont également compatibles pour la réalisation du filtre résonant 10 et permettent, par connexion électrique des différents résonateurs NEMS et sans avoir recours à des composants électroniques de traitement, de profiter de la réponse collective des résonateurs d'une même matrice mais également de celle de différentes matrices reliées parallèlement entre elles, par la sommation de leurs réponses pour une lecture unique de la réponse globale du filtre résonant.

Il est par exemple possible de mesurer la réponse du résonateur en réalisant une détection d'impédance (par exemple variation capacitive, résistive...).

En se référant par exemple à la figure 9, lorsque le corps 1001 du résonateur 1000 est au repos et ne subit aucune force ou déplacement, on peut mesurer une capacité initiale entre le corps 1001 du résonateur 1000 et l'électrode 1014 qui est égale à $C_0 = \dfrac{\varepsilon_0 S}{g_0}$ , avec S surface de l'une des électrodes faisant face à l'autre électrode. Suite au déplacement w résultant d'un actionnement, la distance entre l'électrode 1014 et le corps 1001 varie et par suite, la capacité résultante devient alors $C = \dfrac{\varepsilon_0 S}{g_0 - w(x,t)}$ .

Pour des faibles déplacements, cette capacité peut également s'exprimer sous la forme :

$$C = C_0 + \delta C = C_0 + \dfrac{\varepsilon_0 . S}{g_0^{\,2}} w$$

En tenant en compte de la flexion du corps 1001 et donc de la variation de distance selon l'axe x représenté sur la figure 9, la variation de capacité mesurée électriquement est égale à :

$$\delta C = \dfrac{\varepsilon_0 . b}{g_0^{\,2}} . \int_0^l w(x,t)dx = \left( \dfrac{\varepsilon_0 . b}{g_0^{\,2}} . \int_0^l w_1(x)dx \right) a(t)$$
$$\Rightarrow \delta C(s) = g_d . G(s) . f(s)$$

où $g_d$ représente le gain constant des moyens de détection, dont la valeur dépend de la distance initiale $g_o$ et des dimensions du corps 1001 du résonateur 1000.

Dans le cas général d'une détection d'impédance, suite à une flexion, le corps 1001 subit une variation de l'impédance dZ mesurée électriquement, telle que :

$$\Rightarrow \delta Z(s) = g_d . G(s) . f(s)$$

avec $g_d$ un gain constant dépendant du coefficient de détection et des dimensions du corps 1001.

Chaque impédance variable, avec $\delta Z \ll Z_0$, est équivalente à deux impédances en parallèle de valeurs $Z_0$ et

$\dfrac{-Z_0^2}{\delta Z}$ . En calculant l'impédance équivalente de la matrice, on trouve l'équation du courant global suivante :

$$i = \frac{V}{mZ_0 / n} - \frac{V . \sum\limits_{i=1}^{n \times m} \delta Z_i}{m^2 Z_0^2}$$

La réponse fréquentielle globale de toute la matrice est alors définie par :

$$H(s) = \frac{\delta i(s)}{f(s)} = - \frac{V . g . \sum\limits_{i=1}^{n \times m} G_i(s)}{m^2 Z_0^2}$$

Dans le cas d'une détection de type capacitif, et pour des variations de capacités faibles par rapport aux capacités initiales, la connexion électrique des résonateurs NEMS permet aussi d'obtenir, par une seule sortie mesurée (par exemple la tension de sortie), une réponse globale exprimée par la somme des réponses fréquentielles individuelles des résonateurs.

Dans le cas où les fonctions de transferts individuelles G(s) des résonateurs sont identiques, $H(s)$ prendra la même forme que $G(s)$ mais avec un gain $n/m$ fois plus grand.

Dans le cas où les $G_i(s)$ sont dispersées et comportent des fréquences de résonance différentes, $H(s)$ comporte alors plusieurs pics qui peuvent être superposés et dont le gain s'étale entre $1/m^2$ et $n/m$, selon la dispersion. Si la distribution des $\omega_{0i}$ est uniforme dans un intervalle défini, une réponse finale d'un filtre passe bande presque carré sera obtenue avec un gain égal à celui des $G_i(s)$. En fait, dans le cas de résonateurs idéaux ($Q \to \infty$), la réponse fréquentielle de la somme des $G_i(s)$ tend à suivre exactement la forme de distribution des $\omega_{0i}$. Cette dernière est continue pour une réponse globale continue et non « bruitée », ce qui se traduit par un nombre N équivalent de résonateurs qui tend vers l'infini. Toutefois, il faut noter que les changements de phase des réponses individuelles ajoutent des distorsions sur la forme du gain global par rapport à la forme exacte de la distribution et que le facteur de qualité non idéal (fini) « aplanit » ces distorsions ainsi que les discontinuités dans le cas d'un nombre réduit de résonateurs NEMS (distribution discontinue).

On peut tirer alors la conclusion que pour une même dispersion des fréquences de résonance :

- Si $Q$ est élevé, la forme de $|H(s)|$ est plus affectée par la forme de la distribution des fréquences de résonance que par la réponse individuelle des résonateurs. Il n'y a donc pas d'effet « d'aplanissement » du facteur de qualité, donc $N$ est assez important pour une réponse globale lisse.
- Si $N$ est faible, la répartition des fréquences de résonance est discontinue et $|H(s)|$ est donc bruitée. Un $Q$ plus faible « aplanira » donc la forme du gain global sans changer l'allure générale de la réponse.

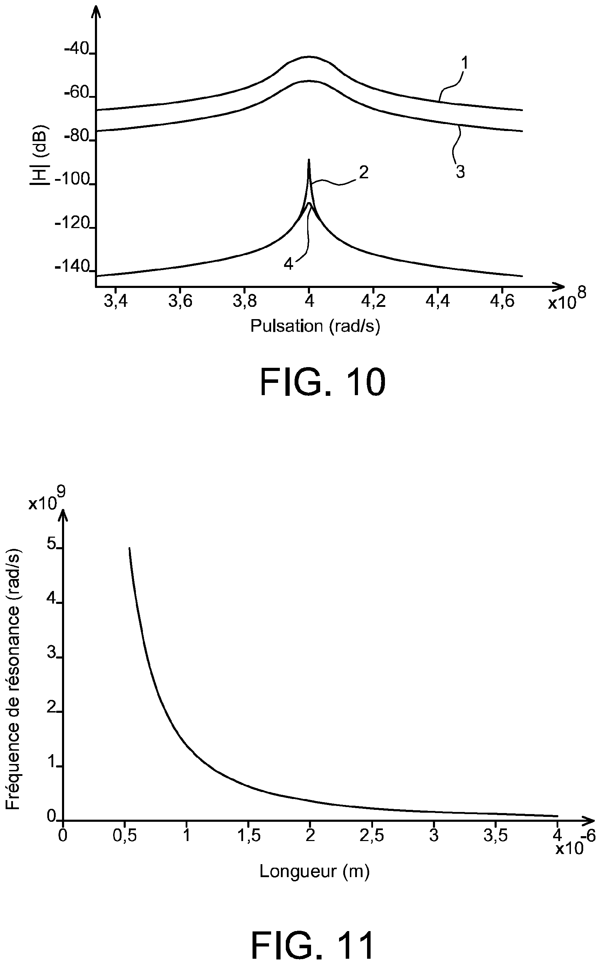

La structure résonante réalisée à partir de ce type de matrice permet donc d'obtenir à partir de résonateurs à facteurs de qualité dégradés une réponse sensiblement similaire à celle obtenue dans le cas de résonateurs à facteurs de qualité élevés, tout en faisant appel à un nombre inférieur de résonateurs et en assurant un gain très élevé. Ceci est illustré par les courbes représentées sur la figure 10. Sur cette figure, les courbes 1 et 2 représentent la réponse globale d'un filtre résonant tel que décrit précédemment comportant 6000 résonateurs NEMS avec $Q = 1500$, les courbes 3 et 4 représentant celle d'un filtre résonant tel que décrit précédemment comportant 3000 résonateurs NEMS avec $Q = 150$. On retrouve presque la même forme plus affectée par la dispersion que par les facteurs de qualité des résonateurs NEMS.

La fabrication des résonateurs NEMS est généralement soumise à des erreurs sur les dimensions des résonateurs, surtout en ce qui concerne leurs longueurs par exemple dans le cas de résonateurs de type poutre. Cette dispersion peut être considérée comme gaussienne autour de la longueur nominale de consigne et avec un écart-type d'environ 10 nm (un exemple). Ceci conduit à des dispersions dans les fréquences de résonance des NEMS d'une même matrice.

La relation liant la fréquence de résonance à la longueur de la poutre est la suivante :

$$\omega_{0_i} = \sqrt{\frac{k_i}{m}} = \sqrt{\frac{E.I.\lambda_1^4}{\rho_{Si}.S}}$$

Soit $\omega_{0_i} = \left(1.8751\right)^2.e.\sqrt{\frac{E}{12.\rho_{Si}}}.\frac{1}{l_i^2}$ lorsque la poutre comporte une extrémité libre.

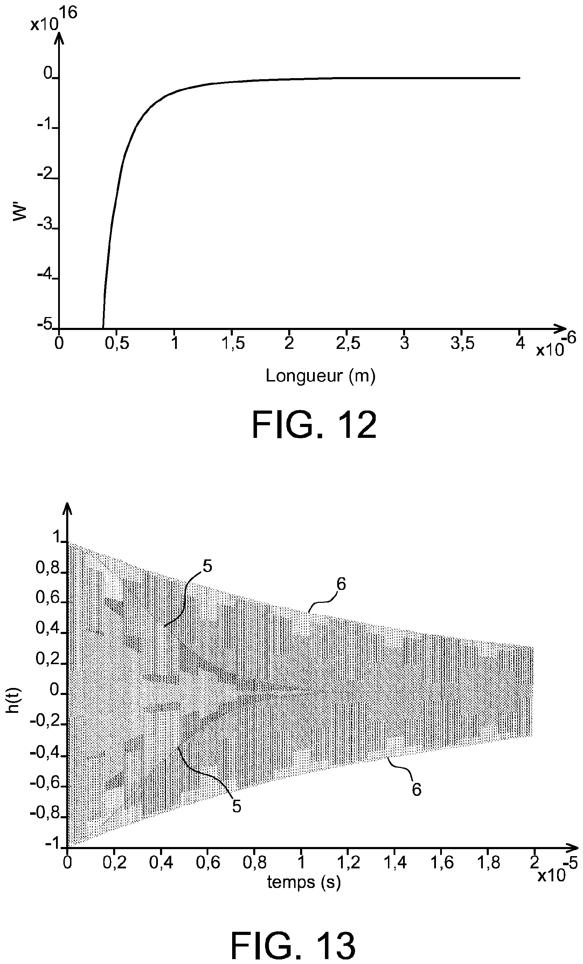

La dispersion résultante de variations de longueurs est illustrée par la figure 11 représentant, dans le cas de résonateurs de type poutre, la fréquence de résonance d'un résonateur NEMS 1000 en fonction de la longueur de son corps 1001 et la figure 12 représentant la dérivée de la fréquence de résonance du résonateur 1000 par rapport à la longueur de son corps 1001.

Pour une même dispersion sur les longueurs et dans le cas où ces dernières sont faibles, les fréquences de résonance correspondantes sont élevées et leur distribution considérée comme gaussienne avec une fréquence nominale $\omega_{0n}$ et un écart-type $\sigma$ important. Dans le cas de longueurs plus importantes, on a beaucoup moins de dispersion sur les fréquences de résonance qui sont aussi plus basses. Le choix des longueurs des résonateurs à réaliser dépend donc de la dispersion des fréquences désirée et par suite de la bande passante résultante désirée suivant l'application à envisager.

Comme la fréquence de résonance des poutres définit une variable aléatoire, la réponse globale l'est donc aussi. Par la loi statistique des grands nombres, on peut démontrer que pour un nombre *N* très grand de résonateurs NEMS, la moyenne de la réponse globale, qu'elle soit dans le domaine fréquentiel ou dans le domaine temporel, tend vers l'espérance de la réponse individuelle d'un résonateur et ceci avec un rapport écart-type/moyenne inversement proportionnel à $\sqrt{N}$. Donc l'écart relatif entre la réponse globale du système et sa moyenne théorique calculée devient très faible dans le cas de grandes matrices même pour des importantes dispersions de longueur, ce qui permet de concevoir plus précisément un circuit électronique robuste qui correspond au filtre. On voit donc qu'il y a un intérêt de réaliser des matrices avec un très grand nombre de résonateurs, voire avec le plus grand nombre de résonateurs possible.

La moyenne d'une réponse impulsionnelle calculée pour une matrice de résonateurs NEMS dont les modèles sont approchés par des seconds ordres et la répartition de leurs fréquences de résonances par une gaussienne, est décrite par l'équation suivante :

$$H(t) = N.e^{-t\xi.\omega_{0n} - \frac{\sigma^2}{2}.t^2}.\sin\left(\omega_{0n}t\right)$$

avec $\xi$=1/2.*Q* qui est le facteur d'amortissement.

On déduit que quand $\xi\rightarrow 0$, c'est-à-dire que $Q\rightarrow\infty$, l'amortissement n'est affecté que par l'écart-type de la dispersion $\sigma$ alors que la fréquence de résonance globale du filtre est égale à la fréquence de résonance nominale moyenne de la distribution $\omega_{0n}$.

Ceci est illustré par la comparaison entre cette réponse impulsionnelle globale du filtre et la réponse impulsionnelle d'un seul résonateur NEMS représentées sur la figure 13. Sur cette figure, les courbes 5 délimitent la réponse impulsionnelle globale du filtre résonant, les courbes 6 délimitant la réponse impulsionnelle individuelle d'un unique résonateur NEMS du filtre résonant.

Comme représenté sur la figure 1, plusieurs matrices 100 de résonateurs NEMS peuvent être reliées électriquement entre elles en parallèle afin de réaliser le filtre résonant 10.

Dans un premier exemple, il est possible de réaliser le filtre résonant 10 en reliant électriquement les matrices 100 de NEMS par microcâblage. Un tel filtre résonant peut notamment être utilisé pour réaliser un filtre mécanique passe-bande de hautes fréquences et de gain à rapport signal/bruit élevé tout en s'affranchissant des problèmes de dispersions et de complexité de couplage.

Un tel dispositif résonant 10 peut par exemple être réalisé à partir de 6 matrices 100 connectées en parallèle les unes aux autres comme représenté sur la figure 1. Chacune de ces 6 matrices 100 peut comporter 4800 résonateurs NEMS connectés sous la forme de 240 colonnes et de 25 lignes. Un tel filtre résonant 10 peut par exemple être utilisé pour réaliser un filtre à large bande passante pour des applications de filtrages passe-bande RF et traitement fréquentiel de signaux.

Pour ce genre d'applications, il est possible d'exploiter les dispersions pour élargir la bande passante du filtre en fonction de l'écart-type tout en ayant un gain élevé (par opposition à un seul résonateur à facteur de qualité dégradé ou un couplage de deux ou plusieurs résonateurs de meilleurs facteurs de qualité). De plus, ces filtres sont souvent appliqués à des applications RF ou de très hautes fréquences, d'où l'intérêt de fabriquer des résonateurs NEMS de petite taille en consigne (longueur nominale), par exemple de longueur comprise entre 0,5 $\mu$m et 2 $\mu$m, ou entre 0,5 $\mu$m et 1 $\mu$m, ou même inférieure à 0,5 $\mu$m, assurant ainsi des hautes fréquences de résonance avec une forte dispersion ce qui permet d'obtenir une plus large bande passante.

Suivant l'architecture de filtre proposée précédemment, les résonateurs de chacune des k matrices, avec par exemple k=6, sont conçus avec la même longueur nominale et ces matrices sont connectées en parallèle entre elles pour que leurs courants ou tensions de réponse soient additionnés. De plus, pour un nombre N de résonateurs NEMS suffisamment grand, le comportement du filtre résonant et sa réponse fréquentielle, qui dépendent beaucoup plus de l'écart-type de dispersion que du facteur de qualité, sont alors bien connus (l'écart-type de la réponse globale étant beaucoup plus faible par rapport à sa moyenne que celui d'une réponse individuelle) et figés (indépendants des changements de l'environnement de fonctionnement).

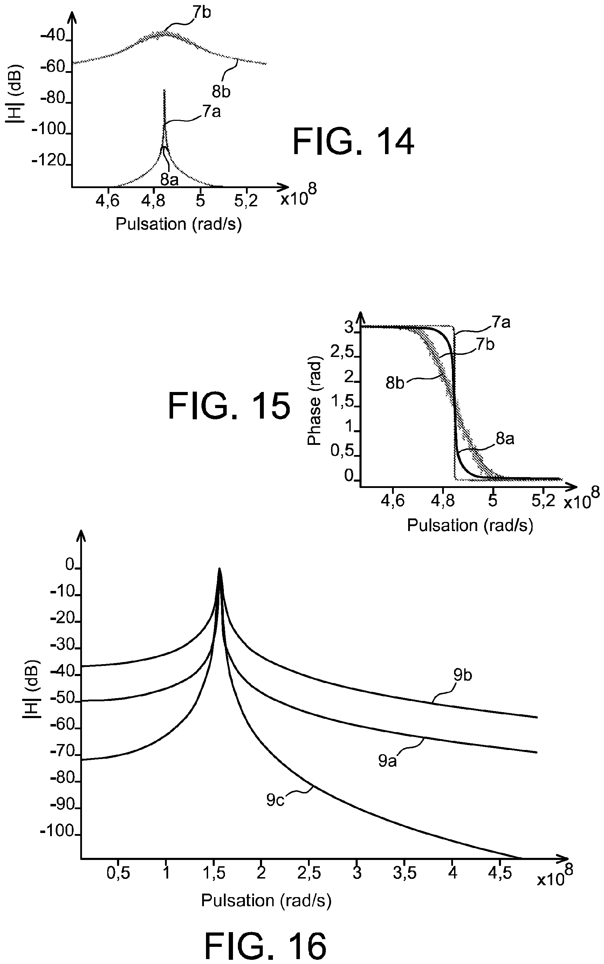

Les figures 14 et 15 représentent les réponses obtenues avec un filtre résonant comportant 6 matrices connectées en parallèle, chacune de 4800 résonateurs NEMS de type poutre. Les résonateurs NEMS de ce filtre ont la même longueur nominale en fabrication qui est fixée à 1,69 $\mu$m. La fréquence de résonance nominale correspondante est de 77 MHz. Les courbes 7b représentent la réponse globale du dispositif résonant avec un facteur de qualité égal à 15000, les courbes 7a représentant la réponse d'une matrice de ce filtre résonant. Les courbes 8b représentent la réponse globale du filtre résonant avec un facteur de qualité égal à 300, les courbes 8a représentant la réponse d'une matrice de ce filtre résonant.

On observe sur ces figures 14 et 15 que la réponse globale est presque identique entre les deux filtres résonants (plus « bruitée » pour le cas de Q = 15000) et la forme amplifiée de son amplitude correspond à la distribution statistique des fréquences de résonance des différents résonateurs. En plus, la phase globale s'étale linéairement sur tout l'intervalle de répartition des fréquences de résonance.

Dans le cas où des bandes passantes plus larges sont désirées, les longueurs nominales des poutres de chaque matrice sont modifiées et choisies d'une façon à ce qu'elles soient décalées de petits intervalles (20 nm par exemple), impliquant des décalages des fréquences de résonance (par exemple 15 MHz), les unes des autres. Ceci permet d'avoir pour tout le filtre une distribution uniforme entre les deux fréquences de résonance nominales du premier et du dernier bloc $\omega_{01}$ et $\omega_{0k}$, et donc $|H(s)|$ prend une forme de passe-bande presque carrée. Là encore, la forme amplifiée de son amplitude correspond à la distribution statistique des fréquences de résonance des différents résonateurs.

Le filtre résonant 10 peut également être utilisé pour réaliser un filtre sélectif à bande passante étroite. Un tel filtre offre également une meilleure atténuation sur les autres fréquences.

Dans ce cas, les longueurs des résonateurs NEMS peuvent être choisies relativement plus grandes, afin que les fréquences de résonance correspondantes soient moins dispersées. De manière générale, les dimensions des résonateurs (par exemple les longueurs des poutres) pourront être inférieures à environ 50 $\mu$m, ou comprise entre 1 $\mu$m et 10 $\mu$m, ou entre 2 $\mu$m et 5 $\mu$m.

Le filtre résonant 10 peut dans ce cas comporter une architecture différentielle formée avec les six matrices de fréquences nominales différentes mais très proches. La sortie des matrices peut être différenciée avec des composants électriques. Afin de ne pas ajouter de composants électroniques pour le traitement et le calcul différentiel des signaux, il est possible de réaliser des moyens de détection qui fourniront, sans composants électroniques supplémentaires, des signaux de valeurs opposées. Les moyens de détection des résonateurs NEMS appartenant à 3 premières matrices, par exemple les matrices 100.1, 100.2 et 100.3, peuvent fournir des signaux électriques de valeurs opposées aux moyens de détection des autres résonateurs appartenant aux 3 autres matrices, à savoir les matrices 100.4, 100.5 et 100.6, et cela pour une même excitation des résonateurs. Dans le cas d'une détection capacitive, les électrodes fixes de détection sont placées au dessus des résonateurs des 3 premières matrices et les autres sont placées au dessous des résonateurs des 3 autres matrices, aboutissant à des variations capacitives positives pour les 3 premières matrices et négatives pour les 3 autres matrices, pour une même flexion. Ainsi, le courant ou la tension variable en fonction des déplacements mesurés en sortie du filtre représente la réponse différentielle globale du filtre.

Ceci est illustré par les réponses fréquentielles obtenues pour des longueurs nominales de poutres des résonateurs NEMS des deux ensembles de matrices de 3,005 $\mu$m et 2,995 $\mu$m respectivement, représentées sur la figure 16. La réponse fréquentielle d'un résonateur NEMS seul est représentée par la courbe 9a. La réponse fréquentielle du filtre lorsque les sorties des deux ensembles de matrices ne sont pas traitées de manière différentielle, mais de manière additive, est représentée par la courbe 9b. Enfin, La réponse fréquentielle du filtre lorsque les sorties des deux ensembles de matrices sont traitées de manière différentielle est représentée par la courbe 9c.

De manière générale, l'écart entre les dimensions des résonateurs des deux ensembles de matrices peut être compris entre environ 1% et 50%. Cet écart sera notamment choisi en fonction des caractéristiques souhaitées pour le filtre et notamment sa bande passante.

Les mêmes avantages précédemment cités concernant le filtre dont les sorties des matrices sont traitées de manière additive sont conservés concernant la réponse du filtre connue et figée qui simplifiera la conception du circuit électronique de traitement qui est associé, ainsi que le gain élevé. De plus, dans ce cas, la phase s'étale encore plus linéairement sur l'intervalle de répartition des fréquences de résonance du système et change de 360 degrés au lieu de 180 degrés, ce qui facilite le contrôle de phase suite à l'étendue de l'intervalle d'accrochement dans le cas de suivi de fréquences de résonance du filtre global par boucle fermée. Le gain statique est beaucoup plus faible et les bruits de hautes fréquences sont fortement rejetés car la réponse possède une atténuation très importante en dehors de la bande passante. La bande passante est plus étroite que celle obtenue par l'architecture décrite précédemment et la sélectivité est accrue.

Un filtre résonant dont les sorties de deux ensembles de matrices de résonateurs NEMS sont traitées de manière différentielle permet donc d'obtenir un filtre sélectif à facteur de qualité élevé et à phase linéaire, détectant ainsi la variation de la fréquence de résonance du système global et mesurant par suite la variation des paramètres du résonateur (constante de raideur, facteur de qualité, etc.) dépendant des phénomènes extérieurs.

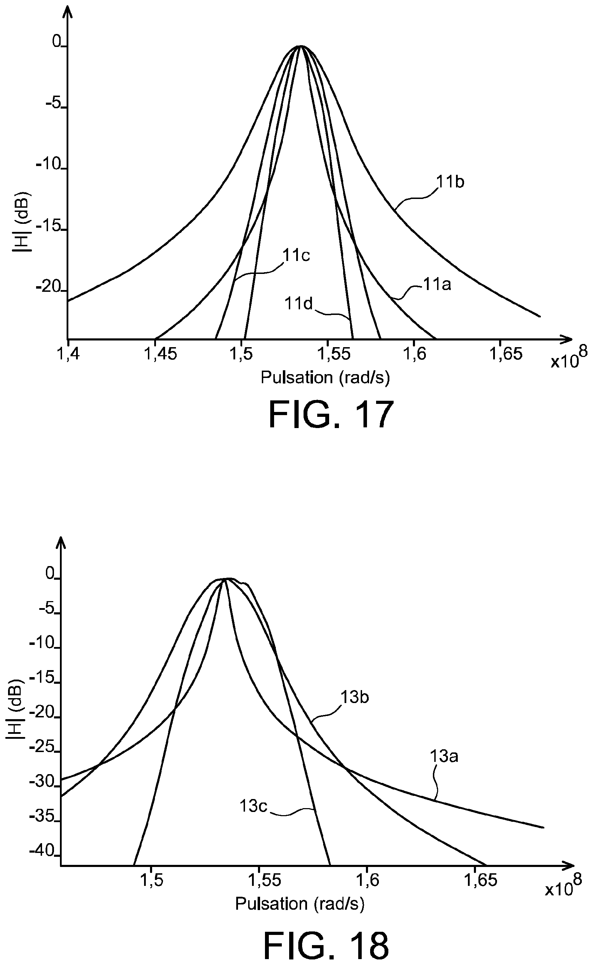

Il est possible d'augmenter encore plus la sélectivité en couplant plusieurs filtres en cascade, c'est-à-dire connectés en série. La courbe 11a représentée sur la figure 17 illustre la réponse fréquentielle nominale d'un résonateur NEMS. La courbe 11b représente la réponse fréquentielle pour un seul filtre résonant dont les sorties sont traitées de manière additive. La courbe 11c représente la réponse fréquentielle pour deux filtres résonants en cascade dont les sorties sont traitées de manière additive. Enfin, la courbe 11d représente la réponse fréquentielle pour trois filtres résonants en cascade dont les sorties sont traitées de manière additive.

La structure de filtres en cascade permet de gagner encore plus de sélectivité lorsque les sorties de ces filtres sont traitées de manière différentielle. Ceci est illustré sur la figure 18 : la courbe 13a représente la réponse fréquentielle d'un résonateur NEMS seul, la courbe 13b représente la réponse fréquentielle de deux filtres résonants en cascade dont les sorties sont traitées de manière additive, la courbe 13c représentant la réponse fréquentielle de deux filtre résonants en cascade dont les sorties dont traitées de manière différentielle.

## Revendications

1. Filtre résonnant (10) comportant au moins deux matrices (100.1 à 100.6) présentant des réponses fréquentielles différentes, chacune des matrices comportant n × m résonateurs (1000) de type NEMS ou MEMS de dimensions sensiblement similaires et répartis sur n lignes et m colonnes, avec n et m entiers strictement supérieurs à 1, comportant pour chaque résonateur (1000) :

   - des moyens d'actionnement aptes à exciter le résonateur (1000) par la commande d'un signal électrique d'entrée du filtre (10),
   - des moyens de détection des déplacements du résonateur (1000) aptes à délivrer un signal électrique de sortie dont la valeur est fonction des déplacements détectés ;

   une entrée (12) du filtre (10), destinée à recevoir un signal électrique d'entrée du filtre, étant reliée électriquement aux moyens d'actionnement de tous les résonateurs (1000), les sorties des moyens de détection de tous les résonateurs (1000) étant reliées électriquement entre elles et à une sortie (14) du filtre (10), les résonateurs (1000) n'étant pas couplés mécaniquement entre eux, et les dimensions nominales des résonateurs d'une matrice étant différentes des dimensions nominales des résonateurs d'une autre matrice.

2. Filtre (10) selon la revendication 1, dans lequel une différence entre les dimensions nominales des résonateurs de ladite une matrice et les dimensions nominales des résonateurs de ladite autre matrice est comprise entre environ 1% et 50%.

3. Filtre (10) selon l'une des revendications précédentes, dans lequel chaque matrice (100.1 à 100.6) comporte un nombre de résonateurs (1000) tel que la moyenne de la réponse globale obtenue en sortie tend vers l'espérance de la réponse individuelle d'un résonateur (1000).

4. Filtre (10) selon l'une des revendications précédentes, dans lequel les résonateurs (1000) sont de type poutre (1001), lesdites dimensions des résonateurs correspondant aux longueurs des poutres (1001).

5. Filtre (10) selon l'une des revendications précédentes, dans lequel les moyens d'actionnement d'au moins une partie des résonateurs (1000) sont de type électrostatique.

6. Filtre (10) selon la revendication 5, dans lequel des moyens d'actionnement de type électrostatique d'un résonateur comporte une première électrode formée par au moins une partie (1001) du résonateur (1000) à base d'un matériau électriquement conducteur et une seconde électrode (1014) espacée de la première électrode (1001), une tension de commande étant destinée à être appliquée entre les deux électrodes (1001, 1014).

7. Filtre (10) selon la revendication 6, dans lequel les secondes électrodes (1014) de moyens d'actionnement de type électrostatique sont formées par une électrode commune à tous les résonateurs (1000) de la matrice (100.1 à 100.6).

8. Filtre (10) selon l'une des revendications précédentes, dans lequel des moyens de détection d'au moins une partie des résonateurs (1000) sont de type capacitif.

9. Filtre (10) selon la revendication 8, dans lequel les moyens de détection de type capacitif d'un résonateur comportent des moyens de mesure de capacité entre une portion électriquement conductrice (1001) du résonateur (1000) et une électrode (1014) espacée de ladite portion électriquement conductrice (1001).

10. Filtre (10) selon l'une des revendications précédentes, comportant une pluralité de matrices (100.1 à 100.6) de résonateurs (1000) de type N/MEMS reliées électriquement et en parallèle les unes aux autres de sorte que le signal électrique destiné à être obtenu en sortie du filtre correspond à la somme des signaux électriques obtenus en sortie de chaque matrice.

11. Filtre (10) selon la revendication 10, dans lequel les matrices (100.1 à 100.6) sont connectées électriquement entre elles par microcâblage.

12. Filtre (10) selon l'une des revendications 10 ou 11, dans lequel des moyens de détection des résonateurs (1000) d'au moins une première matrice (100.1 à 100.3) sont aptes à délivrer des signaux électriques de valeurs opposées aux valeurs de signaux électriques destinés à être délivrés par des moyens de détection des résonateurs (1000) d'au moins une deuxième matrice (100.4 à 100.6), les dimensions des résonateurs (1000) de ladite au moins une première matrice (100.1 à 100.3) étant différentes de celles des résonateurs (1000) de ladite au moins une deuxième matrice (100.4 à 100.6).

13. Filtre (10) selon l'une des revendications 12, dans lequel des moyens de détection des résonateurs (1000) d'un nombre de premières matrices (100.1 à 100.3) correspondant à la moitié du nombre total de matrices du filtre (10) sont aptes à délivrer des signaux électriques de valeurs opposées aux valeurs de signaux électriques destinés à être délivrés par des moyens de détection des résonateurs (1000) d'un nombre de deuxièmes matrices (100.4 à 100.6) correspondant à la moitié du nombre total de matrices du filtre (10).

14. Filtre (10) selon l'une des revendications précédentes, ledit filtre (10) étant réalisé sur un unique substrat.

15. Filtre (10) selon l'une des revendications précédentes, dans lequel la matrice (100.1 à 100.6) comporte entre environ 50 résonateurs et 10000 résonateurs.

16. Structure résonante comportant plusieurs filtres résonants (10) selon l'une des revendications 1 à 15 couplés électriquement en série les uns aux autres.


**Patentansprüche**

1. Resonanzfilter (10), umfassend wenigstens zwei Matrizen (100.1 bis 100.6), die verschiedene Frequenzantworten aufweisen, wobei jede der Matrizen n x m Resonatoren (1000) vom Typ NEMS oder MEMS mit im Wesentlichen gleichen Abmessungen umfasst, die auf n Zeilen und m Spalten verteilt sind, wobei n und m ganze Zahlen streng größer als 1 sind, umfassend für jeden Resonator (1000):

    - Betätigungsmittel, die dazu ausgelegt sind, den Resonator (1000) durch die Steuerung eines elektrischen Eingangssignals des Filters (10) zu erregen,
    - Mittel zur Erfassung der Verlagerungen des Resonators (1000), die dazu ausgelegt sind, ein elektrisches Ausgangssignal zu liefern, dessen Wert eine Funktion der erfassten Verlagerungen ist;

    wobei ein Eingang (12) des Filters (10), der dazu ausgelegt ist, ein elektrisches Eingangssignal des Filters zu empfangen, elektrisch mit den Betätigungsmitteln von allen Resonatoren (1000) verbunden ist, wobei die Ausgänge der Erfassungsmittel von allen Resonatoren (1000) elektrisch miteinander und mit einem Ausgang (15) des Filters (10) verbunden sind, wobei die Resonatoren (1000) mechanisch nicht miteinander verbunden sind, und wobei die nominalen Abmessungen der Resonatoren einer Matrix von den nominalen Abmessungen der Resonatoren einer anderen Matrix verschieden sind.

2. Filter (10) nach Anspruch 1, bei dem eine Differenz zwischen den nominalen Abmessungen der Resonatoren der einen Matrix und den nominalen Abmessungen der Resonatoren der anderen Matrix zwischen ungefähr 1% und 50% enthalten ist.

3. Filter (10) nach einem der vorhergehenden Ansprüche, bei dem jede Matrix (100.1 bis 100.6) eine derartige Zahl von Resonatoren (1000) umfasst, dass der Durchschnitt der globalen Antwort, die am Ausgang erhalten wird, gegen den Erwartungswert der individuellen Antwort eines Resonators (1000) tendiert.

4. Filter (10) nach einem der vorhergehenden Ansprüche, bei dem die Resonatoren (1000) vom Typ Balken (1001) sind, wobei die Abmessungen der Resonatoren den Längen der Balken (1001) entsprechen.

5. Filter (10) nach einem der vorhergehenden Ansprüche, bei dem die Betätigungsmittel von wenigstens einem Teil der Resonatoren (1000) vom elektrostatischen Typ sind.

6. Filter (10) nach Anspruch 5, bei dem die Betätigungsmittel vom elektrostatischen Typ eines Resonators eine erste Elektrode umfassen, die durch wenigstens einen Teil (1001) des Resonators (1000) auf Basis eines elektrisch leitenden Materials gebildet ist, und eine zweite Elektrode (1014), die von der ersten Elektrode (1001) beabstandet ist, wobei eine Steuerspannung zwischen den beiden Elektroden (1001, 1014) angelegt werden kann.

7. Filter (10) nach Anspruch 6, bei dem die zweiten Elektroden (1014) der Betätigungsmittel vom elektrostatischen Typ durch eine Elektrode gebildet sind, die allen Resonatoren (1000) der Matrix (100.1 bis 100.6) gemeinsam ist.

8. Filter (10) nach einem der vorhergehenden Ansprüche, bei dem die Erfassungsmittel wenigstens eines Teils der Resonatoren (1000) vom kapazitiven Typ sind.

9. Filter (10) nach Anspruch 8, bei dem die Erfassungsmittel vom kapazitiven Typ eines Resonators Mittel zum Messen der Kapazität zwischen einem elektrisch leitenden Bereich (1001) des Resonators (1000) und einer Elektrode (1014) umfassen, die von dem elektrisch leitenden Bereich (1001) beabstandet ist.

10. Filter (10) nach einem der vorhergehenden Ansprüche, umfassend eine Mehrzahl von Matrizen (100.1 bis 100.6) von Resonatoren (1000) vom Typ N/MEMS, die elektrisch und parallel zueinander derart verbunden sind, dass das elektrische Signal, das am Ausgang des Filters erhalten werden soll, der Summe der elektrischen Signale entspricht, die am Ausgang jeder Matrix erhalten werden.

11. Filter (10) nach Anspruch 10, bei dem die Matrizen (100.1 bis 100.6) elektrisch miteinander durch Mikroverkabelung verbunden sind.

12. Filter (10) nach einem der Ansprüche 10 oder 11, bei dem die Erfassungsmittel der Resonatoren (1000) von wenigstens einer ersten Matrix (100.1 bis 100.3) dazu ausgelegt sind, elektrische Signale mit Werten zu liefern, die entgegengesetzt sind zu den Werten von elektrischen Signalen, welche durch die Erfassungsmittel der Resonatoren (1000) von wenigstens einer zweiten Matrix (100.4 bis 100.6) geliefert werden sollen, wobei die Abmessungen der Resonatoren (1000) der wenigstens einen ersten Matrix (100.1 bis 100.3) verschieden sind von jenen der Resonatoren (1000) der wenigstens einen zweiten Matrix (100.4 bis 100.6).

13. Filter (10) nach einem der Ansprüche 12, bei dem die Erfassungsmittel der Resonatoren (1000) einer Zahl von ersten Matrizen (100.1 bis 100.3) entsprechend der Hälfte der Gesamtzahl von Matrizen des Filters (10) dazu ausgelegt sind, elektrische Signale mit Werten zu liefern, die entgegengesetzt sind zu den Werten von elektrischen Signalen, die durch die Erfassungsmittel der Resonatoren (1000) einer Zahl von zweiten Matrizen (100.4 bis 100.6) entsprechend der Hälfte der Gesamtzahl von Matrizen des Filters (10) geliefert werden sollen.

14. Filter (10) nach einem der vorhergehenden Ansprüche, wobei das Filter (10) auf einem einzigen Substrat realisiert ist.

15. Filter (10) nach einem der vorhergehenden Ansprüche, bei dem die Matrix (100.1 bis 100.6) zwischen ungefähr 50 Resonatoren und 10000 Resonatoren umfasst.

16. Resonanzstruktur, umfassend mehrere Resonanzfilter (10) nach einem der Ansprüche 1 bis 15, die elektrisch in Reihe miteinander gekoppelt sind.

**Claims**

1. Resonant filter (10) including at least two matrix (100.1 to 100.6) having different frequency responses, each matric comprising of $n \times m$ resonators (1000) of the NEMS or MEMS type with substantially similar dimensions and distributed in n rows and m columns, with n and m being integers strictly greater than 1, including for each resonator (1000):

   - actuating means able to excite the resonator (1000) by controlling an input electric signal of the filter (10),
   - means for detecting movements of the resonator (1000) able to output an electrical output signal whereof the value depends on the detected movements;

   an input (12) of the filter (10), intended to receive an electrical input signal of the filter, being electrically connected to the actuating means of all of the resonators (1000), the outputs of the detecting means of all of the resonators (1000) being electrically connected to each other and to an output (14) of the filter (10), the resonators (1000) not being mechanically coupled to each other, and the nominal dimensions of the resonators of one matrix being different than the nominal dimensions of the resonators of another matrix.

2. Filter (100) according to claim 1, wherein a difference between the nominal dimensions of the resonators of said one matrix and the nominal dimensions of the resonators of said another matrix is between around 1% and 50 %.

3. Filter (10) according to one of the previous claims, wherein each matrix (100.1 to 100.6) includes a number of resonators (1000) such that the average of the global response obtained as output tends toward the expected value of the individual response of a resonator (1000).

4. Filter (10) according to one of the previous claims, wherein the resonators (1000) are of the beam type (1001), said dimensions of the resonators corresponding to the lengths of the beams (1001).

5. Filter (10) according to one of the previous claims, wherein the actuating means of at least part of the resonators (1000) are of the electrostatic type.

6. Filter (10) according to claim 5, wherein actuating means of the electrostatic type of a resonator include a first electrode formed by at least one part (1001) of the resonator (1000) based on an electrically conductive material and a second electrode (1014) spaced away from the first electrode (1001), a control voltage being intended to be applied between the two electrodes (1001, 1014).

7. Filter (10) according to claim 6, wherein the second electrodes (1014) of actuating means of the electrostatic type are formed by an electrode shared by all of the resonators (1000) of the matrix (100.1 to 100.6).

8. Filter (10) according to one of the previous claims, wherein the detecting means of at least part of the resonators (1000) are of the capacitive type.

9. Filter (10) according to claim 9, wherein the detecting means of the capacitive type of a resonator include capacity measuring means between an electrically conductive portion (1001) of the resonator (1000) and an electrode (1014) spaced away from said electrically conductive portion (1001).

10. Filter (10) according to one of the previous claims, including a plurality of matrices (100.1 to 100.6) of N/MEMS-type resonators (1000) electrically connected and parallel to each other such that the electrical signal intended to be obtained as output of the filter corresponds to the sum of the electrical signals obtained as output of each matrix.

11. Filter (10) according to claim 10, wherein the matrices (100.1 to 100.6) are electrically connected to each other by wire bonding.

12. Filter (10) according to one of claims 10 or 11, wherein detecting means of the resonators (1000) of at least one first matrix (100.1 to 100.3) are able to output electrical signals with values opposite to the electrical signal values intended to be outputted by detecting means of the resonators (1000) of at least one second matrix (100.4 to 100.6), the dimensions of the resonators (1000) of said at least one first matrix (100.1 to 100.3) being different from those of the resonators (1000) of said at least one second matrix (100.4 to 100.6).

13. Filter (10) according to claim 12, wherein detecting means of the resonators (1000) of a number of first matrices (100.1 to 100.3) corresponding to half the total number of matrices of the filter (10) being able to output electrical signals of values opposite the electrical signal values intended to be outputted by detecting means of the resonators (1000) of a number of second matrices (100.4 to 100.6) corresponding to half the total number of matrices of the filter (10).

14. Filter (10) according to one of the previous claims, said filter (10) being made on a single substrate.

15. Filter (10) according to one of the previous claims, wherein the matrix (100.1 to 100.6) includes between about 50 resonators and 10,000 resonators.

16. Resonant structure including several resonant filters (10) according to one of claims 1 to 15 electrically coupled to each other in series.

10

100.1
100.2
100.3
12          14
100.4
100.5
100.6

# FIG. 1

100

1000.21    1000.11
1000.12    1000.22
1000.1m
1000.2m
101                                              104

1000.n1          1000.n2
1000.nm

# FIG. 2

FIG. 3

FIG. 4

FIG. 5

# FIG. 6

# FIG. 7

FIG. 8

FIG. 9

FIG. 10

FIG. 11

FIG. 12

FIG. 13

FIG. 14

FIG. 15

FIG. 16

FIG. 17

FIG. 18

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20060170508 A

**Littérature non-brevet citée dans la description**

- **J.R. CLARK et al.** Parallel-Coupled Square-Resonator Micromechanical Filter Arrays. *Proceedings of the 2006 IEEE International Frequency Control Symposium,* 485-490

- **DE S.-H. SHEN.** Design considerations for an acoustic MEMS filter. *Microsystem Technologies,* 2004, vol. 10, 585-591